# EUROPEAN PATENT APPLICATION

(11) **EP 2 172 577 A2**
(43) Date of publication of application: **07.04.2010**
(21) Application number: 09172057.3
(22) Date of filing: 02.10.2009
(51) Int. Cl.: C23C 14/06, C23C 14/02, F01D 5/28

(54) **Surface treatments for turbine components to reduce particle accumulation during use thereof**

(30) Priority: 03.10.2008 US 244918
(71) Applicant: General Electric Company, Schenectady, NY 12345 (US)
(72) Inventor: Varanasi, Kripa Kiran, Clifton Park, NY 12065 (US); Bhate, Nitin, Rexford, NY 12148 (US); Carroll, Michael David, West Chester, OH 45069 (US); Ghasripoor, Farshad, Scotia, NY 12302 (US); Kulkarni, Ambarish Jayant, Niskayuna, NY 12309 (US); Rosenzweig, Larry Steven, Clifton Park, NY 12065 (US); Schell, Jerry Donald, Cincinnati, OH 45241 (US); Zhong, Dalong, Niskayuna, NY 12309 (US)
(74) Representative: Szary, Anne Catherine

(57) **Abstract**

A turbine engine component (10) includes at least one treated surface (14) wherein the treated surface has a surface roughness (Ra) of less than 12 microinches; and a hard coating (16) disposed on the treated surface, wherein the hard coating (16) is a nitride and/or a carbide material at a thickness of less than 50 microns formed using electron beam physical vapor deposition, cathodic arc evaporation, or magnetron sputtering. Also disclosed are methods for substantially preventing micropitting on a surface of a turbine engine component (10).

## Description

### BACKGROUND

The present disclosure generally relates to turbine engine components having surface treatments effective to reduce particle accumulation during use.

Metal components are used in a wide variety of industrial applications, under a diverse set of operating conditions. Existing base materials for turbine components such as, but not limited to, martensitic stainless steels do not have adequate erosion or corrosion resistance under these conditions. The severe erosion that can result may damage the turbine components, thereby contributing to frequent maintenance related shutdowns, loss of operating efficiencies, and the need to replace various components on a regular basis. In many cases, the components are provided with coatings, which impart various characteristics, such as corrosion resistance, heat resistance, oxidation resistance, and erosion resistance. As an example, erosion-resistant coatings are frequently used on the first stages of high pressure and intermediate pressure steam turbines that are particularly prone to solid particle erosion. In addition, erosion-resistant coatings are frequently used on compressor sections of gas turbines and jet engines that are prone to sand or other airborne solid particle erosion as well as corrosion.

In addition to erosion and corrosion, sand fouling has recently emerged as a key factor significantly degrading performance in turbine components. For example, aircraft engines flying domestic routes often experience significant sand fouling due to heavy sand intake during flight idle, take off, and landing. It has been determined that the primary mechanism for fouling is the increased roughness of compressor blades due to sand ingestion. Specifically, this increased roughness results from the formation of micropits due to particle impact. Subsequently, sand particles with sizes less than 10 microns accumulate in these pits to form the fouling layers. High temperatures in the downstream stages of the compressor result in baking of the sand particles, which increases the airfoil-sand adhesion. Consequently, water wash as is frequently used to clean the turbine components is not successful in removing the accumulated sand particles.

Various anti-erosion coatings have been developed to mitigate erosion that results in macro-scale material loss. Such coatings include ceramic coatings of alumina, titania, chromia, and the like, that are frequently deposited by thermal spray techniques, such as air plasma spray (APS) and high velocity oxy-fuel (HVOF). These processes produce as-deposited coatings with relatively rough surface textures and limited hardness, which can have adverse affects on the performance of the turbine. As will be discussed in greater detail below, increased surface roughness has been found to be a direct contributor to sand accumulation. Moreover, erosion, if any, of such coatings significantly degrades the surface roughness, accelerating sand fouling. In addition, these processes can produce coatings that can adversely affect the high cycle fatigue strength of the substrate or base material. Finally, the coatings produced by these processes often require modification to the turbine airfoil to compensate for the thickness of the coatings.

Accordingly, there remains a need in the art for turbine engine components having surfaces that are substantially resistant to sand fouling and exhibit a minimal or no decrease in surface finish, hardness, high cycle fatigue strength under particle impact, and have a minimal effect on the airfoil area and surface profile.

### BRIEF SUMMARY

Disclosed herein are surfaces of turbine engine components and methods that substantially prevent micropitting as a result of particle impact during use. In one embodiment, the surface of a turbine engine component that is resistant to sand fouling comprises a substrate; and a carbide and/or nitride coating deposited thereon, wherein the coated surface has a roughness (Ra) of less than 12 microinches.

A method for substantially preventing micropitting on a surface of a turbine engine component, comprises treating the surface of the turbine engine component to provide an average roughness (Ra) of less than 12 microinches; and depositing a nitride and/or a carbide coating onto the treated surface at a thickness of less than 50 microns by electron beam physical vapor deposition, cathodic arc evaporation, or magnetron sputtering.

In another embodiment, a method for substantially preventing micropitting on a surface of a turbine engine component comprises depositing a nitride and/or a carbide coating onto the surface at a thickness of less than 50 microns by electron beam physical vapor deposition, cathodic arc evaporation, or magnetron sputtering; and treating the coated surface of the turbine engine component to provide an average roughness (Ra) of less than 12 microinches.

The disclosure may be understood more readily by reference to the following detailed description of the various features of the disclosure and the examples included therein.

### BRIEF DESCRIPTION OF THE DRAWINGS

Referring now to the figures wherein the like elements are numbered alike:
FIG. 1 are scanning electron micrographs of a turbine blade component surface before and after use.
FIG. 2 is a cross sectional view of a portion of a turbine engine component.
FIG. 3 graphically illustrates surface roughness for a turbine blade component having a standard finish, a superfinish, and a titanium nitride coating at different thicknesses disposed on a superfinish surface.
FIG. 4 are scanning electron micrographs of an uncoated turbine blade component surfaces at different locations after exposure to a sand erosion test.
FIG. 5 are scanning electron micrographs of a turbine blade component surface before and after exposure to a sand erosion test and stripping process.
FIG. 6 graphically illustrates surface roughness for coated and uncoated turbine blade components after exposure to a sand erosion test and stripping process.

### DETAILED DESCRIPTION

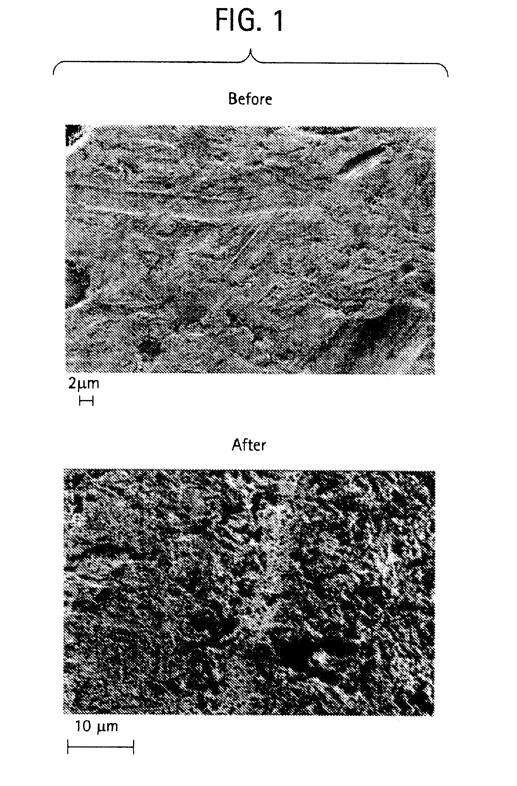

It has been discovered through characterization of fouled turbine components that sand accumulates in micropits formed as a result of the impact of particles, e.g., sand. For example, FIG. 1 illustrates a turbine component surface and the extent of micropit formation caused by the impact of sand particles. FIG. 1 provides a surface comparison of a new turbine blade component relative to a used turbine blade component subjected to sand fouling, wherein both surfaces were treated with the same cleaning solution to remove buildup from the surface. Evidence of micropitting was clearly distinguishable in the surface of the used turbine blade component. Although not shown, prior to treatment with the cleaning solution to remove buildup, sand accumulation was evident on the surfaces of the used turbine blade component. Disclosed herein are surface treatments for a turbine engine component so as to reduce sand accumulation and/or erosion caused by the impact of particles on the turbine component surface during use. The surface treatment generally includes wet blasting, tumbling, and burnishing with chemical compounds the surfaces of the turbine component including those susceptible to sand accumulation and/or erosion to achieve a surface roughness (Ra) of 12 microinches or less; and subsequently applying a carbide and/or a nitride coating onto all or selected surfaces of the turbine component having the prescribed surface roughness. The carbide and/or nitride coating is at a thickness that does not affect the aerodynamic properties of the turbine component. As will be discussed in greater detail herein, the use of the carbide and/or nitride coating in combination with the treated surface substantially reduces the formation of micropits, and as such, reduces sand accumulation. Alternatively, the carbide and/or nitride coating can be applied to the turbine component followed by surface treatment to obtain a surface roughness (Ra) of less than 12 microinches.

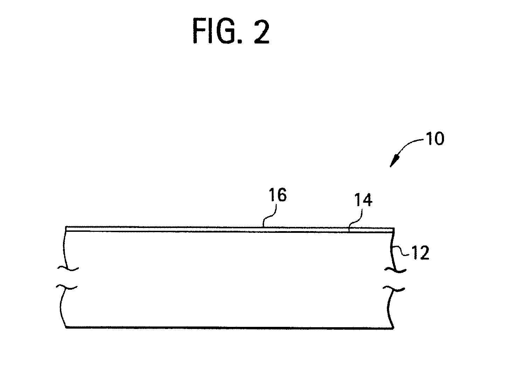

Referring now to FIG. 2, there is depicted a cross sectional view of a portion of turbine engine component generally designated by reference numeral 10. The portion of the turbine engine component generally includes a substrate 12 having a treated surface 14, and a carbide and/or nitride hard coating 16 (i.e., erosion resistant) disposed on the treated surface.

The form of the turbine engine component is not intended to be limited and can vary among a shroud, bucket or blade, nozzle or vane, diaphragm component, seal component, valve stem, nozzle box, nozzle plate, or the like. The terms "blade" and "bucket" can be used interchangeably; generally a blade is a rotating airfoil of an aircraft turbine engine, and a bucket is a rotating airfoil of a land-based power generation turbine engine. Also the term "nozzle", which generally refers to a stationary vane in a steam or gas turbine, can be used interchangeably with the term "vane".

The turbine engine component, i.e., substrate 12, generally comprises steel and/or superalloy as well as titanium alloys (e.g., Ti-6Al-4V. Superalloys are metallic alloys that can be used at high temperatures, often in excess of about 0.7 of the absolute melting temperature. Any Fe--, Co--, or Ni-- based superalloy composition may be used to form the structural component. The most common solutes in Fe--, Co--, or Ni-based superalloys are aluminum and/or titanium. Generally, the aluminum and/or titanium concentrations are low (e.g., less than or equal to about 15 weight percent (wt %) each). Other optional components of Fe--, Co--, or Ni-based superalloys include chromium, molybdenum, cobalt (in Fe-- or Ni-based superalloys), tungsten, nickel (in Fe-- or Co-based superalloys), rhenium, iron (in Co-- or Ni-based superalloys), tantalum, vanadium, hafnium, columbium, ruthenium, zirconium, boron, yttrium, and carbon, each of which may independently be present in an amount of less than or equal to about 15 wt %.

As used herein, the term "treated surface" generally refers to a surface having a surface roughness (Ra) of less than 12 microinches, which is generally attainable by wet blasting, tumbling and burnishing with chemical compounds. An exemplary process for reducing surface roughness is an isotropic superfinishing process that typically results in a non-directional surface texture, although other surface refining methods may be used. The isotropic surface finishing process generally involves vibratory movement between a solid media and the surface region, with or without chemical accelerants, for a period of time effective to produce the surface roughness of less than 12 microinches. Surface roughness (Ra) can be measured in accordance with ISO standard 4287. Previously, these parts were formed by a variety of machining methods such as, for example, machine grinding/polishing process, electro-chemical machining, precision forging, rolling coining processes and the like, that produce surface characteristics and a surface roughness with values typically substantially greater than 16 microinches a, which all produce some surface condition that is not as smooth as desired.

The specific nitride and/or carbide coating 16 composition is chosen to provide erosion resistance to those treated surfaces of the turbine engine component that are typically prone to solid particle erosion. Suitable metal carbides include, without limitation, Cr₃C₂, WC, TiC, ZrC, B₄C, and the like; suitable metal nitrides include, without limitation, BN, TiN, ZrN, HfN, CrN, Cr₂N, Si₃N₄, AlN, TiAlN, CrAlN, TiAlCrN, TiCrN, TiZrN, CrBN, TiBN, and the like; and combinations of carbides and nitrides (e.g., carbonitrides such as TiCN, TiWCN, TiSiCN, NbCN, and the like). Alternatively, the erosion resistant coating can comprise a ceramic-metal carbide composite (cermet). Suitable cermets include WC/Co, WC/CoCr, WC/Ni, TiC/Ni, TiC/Fe, Cr₃C₂/Ni(Cr), TaC/Ni, and combinations comprising at least one of the foregoing.

The carbide and/or nitride coating 16 can have cross-sectional or Vickers hardness (Hᵥ) of up to about 5000 kilograms per square millimeter (kg/mm²). Within this range, the hardness of the erosion resistant coating 16 is greater than or equal to about 500 kg/mm². In one embodiment, the hardness of the coating 16 is greater than or equal to about 1000 kg/mm². In another embodiment, the hardness of the coating 16 is greater than or equal to about 2000 kg/mm². In yet another embodiment, the hardness of erosion resistant coating 16 is less than or equal to about 4000 kg/mm². In still another embodiment, the hardness of the erosion resistant coating 16 is less than or equal to about 3000 kg/mm².

The thickness of the erosion resistant coating is less than 50 microns. In one embodiment, the thickness is less than 30 microns to greater than 10 microns. In another embodiment, the thickness is less than 10 microns.

An exemplary surface treatment process generally includes placing one or more of the turbine components to be "treated" in a vibratory finishing system; adding solid media and chemical solutions to the system; and providing vibratory movement. Suitable solid media for treating the surface include various ceramics, plastics, metals, and the like and are generally described in US Pat. No. 4,491,500; 4,818,333 to REM Chemicals, Inc, and US Pat. No. 7,005,080 to REM Technologies, Inc. The media can be soft or hard as is defined by those patents.

The nitride and/or carbide coating is then deposited onto all or selected treated surfaces of the turbine component. The deposition method is generally based on, but not limited to, an electron beam-physical vapor deposition (EB-PVD), or filtered vacuum/cathodic arc evaporation or magnetron sputtering, which results in coatings with decreased surface roughness relative to existing coatings. Advantageously, the as-deposited coatings do not require a post-deposition machining or polishing step to achieve the decreased surface roughness. Furthermore, the coatings provide increased dimensional stability to the coated surface during operation of the turbine. For example, the coated turbine engine component has a high cycle fatigue (HCF) strength that is greater than or equal to that of the turbine engine component without the erosion resistant coating disposed thereon. Accordingly, adverse effects, such as decreased turbine efficiency and power output, which are often observed in coatings having increased surface roughness, can be reduced. These features ultimately result in increased component and turbine engine lifetimes.

An EB-PVD apparatus suitable for electron beam-physical vapor deposition generally includes a vacuum chamber containing an electron beam source and a water cooled crucible, which holds the source material named target or ingot. A power source is in electrical communication with the electron beam source and various controllers are also included such as vacuum controllers for a vacuum pump coupled to the vacuum chamber, power controllers, and the like. When more than one metal is deposited, a single target comprising an alloy of the metals to be deposited can be vaporized, or multiple targets can be co-vaporized. The deposition chamber is first evacuated to high vacuum, which is typically below 1x10⁻⁵ Torr. During deposition, the target is bombarded with an electron beam. Intense heating of the target by the electron beam causes the surface of the target to melt or sublime, allowing vaporized molecules of the metal to travel upwardly, and then deposit on the surfaces of the substrate. The coating thickness will generally depend on the duration of the coating process and the vapor flux that condenses on the substrate. Introducing a controlled gas into the chamber results in the deposition of a composition that is a compound of the target and the introduced gas on the substrate. For example, a TiN coating can be reactively formed by evaporating a Ti target using electron beam in an atmosphere with a partial pressure of nitrogen. Within the deposition chamber, the substrate can be moved to achieve a uniform coating on various surfaces of the substrate. An ion beam source can also be used in the chamber to assist the deposition so that the coating microstructure can be modified, thereby providing denser and harder coatings.

If only a portion of the substrate is to be coated with the carbide and/or nitride erosion resistant coating, then a mask can be used to cover the portion of the substrate to remain uncoated prior to insertion of the substrate into the deposition chamber. Specific masking techniques, such as hard masking and soft masking, are known to those skilled in the art in view of this disclosure.

The EB-PVD can produce erosion resistant coatings that have the same, or substantially the same, microstructure and/or roughness average as the substrate onto which they are deposited. For example, with EB-PVD, the roughness average of the deposited erosion resistant coating is within about 1 to about 10 percent of the roughness average of the substrate; and with ion plasma cathodic arc deposition, the roughness average of the deposited erosion resistant coating is within about 1 to about 10 percent of the roughness average of the substrate. The smoothness/roughness of the uncoated turbine engine component can be controlled by machining the component to a desired contour and/or dimension. Thus, in an advantageous feature, highly smooth as-deposited erosion resistant coatings can be produced on treated surfaces of the turbine engine components, without needing a post-deposition processing step. In this manner, once the coating step has been completed, the coated turbine component is ready to be used or to undergo subsequent manufacturing processes. An alternate embodiment would involve a coating process (e.g., unfiltered vacuum/cathodic arc evaporation) that produces a rougher coating finish that is subsequently processed, i.e., treated in the manner discussed above, to achieve the desired surface roughness of less than 12 microinches.

It should be recognized that the turbine engine components may comprise other coatings commonly deposited on turbine engine components, such as bond coats, thermal barrier coatings, lubricious coatings, and the like. If the erosion resistant coatings 16 described above are to be deposited on an already coated turbine engine component, then the already coated turbine engine component is intended to be considered as the substrate 12 described above. Deposition of these other types of coatings is known by those skilled in the art.

In addition, the coated turbine engine component 10 can be subjected to other machining operations not intended to alter the surface characteristics of the erosion resistant coating 16. For example, the coated turbine engine component 10 can be welded or otherwise coupled to another component of the overall turbine engine during a post-deposition manufacturing step, as in the case of, for example, a coated nozzle. In this manner, rather than placing the entire nozzle assembly in the deposition chamber (and masking areas where a coating is not desired), smaller components of the turbine engine can be disposed in the deposition chamber and coated with the erosion resistant coating 16.

Furthermore, while not necessary to achieve a smooth coated article 10, the erosion resistant coating 16 can be machined to a specific contour and dimension after the erosion resistant coating 16 has been deposited onto the treated surface 14 of the substrate 12.

The following examples are presented for illustrative purposes only, and are not intended to limit the scope of the invention.

In this example, coated and uncoated turbine blade components were subjected to a sand erosion test. The uncoated turbine blade components included one having a standard surface finish and one having a treated surface. The coated turbine blade components included a TiN layer at a thickness of 3 and 8 microns, respectively, deposited onto a treated surface using EB-PVD in which 3-20 mTorr nitrogen was added to the chamber so as to react with the evaporating titanium target to form titanium nitride. The substrate temperature was about 250 to 500°C. The treated surface was prepared by a tumbling process.

The sand erosion test directed sand particles with nominal sizes ranging from greater than 0 to 3 microns at the various turbine blade components at a flow speed of 0.4 Mach and a flow rate of 4 to 5 grams per minute. The substrates were exposed to the sand for a 45 minute period so as to simulate an aircraft turbine blade exposure of 2000 hours. Upon completion of sand exposure, the sand was stripped from the turbine blade components using a cleaning solvent and the surfaces studied.

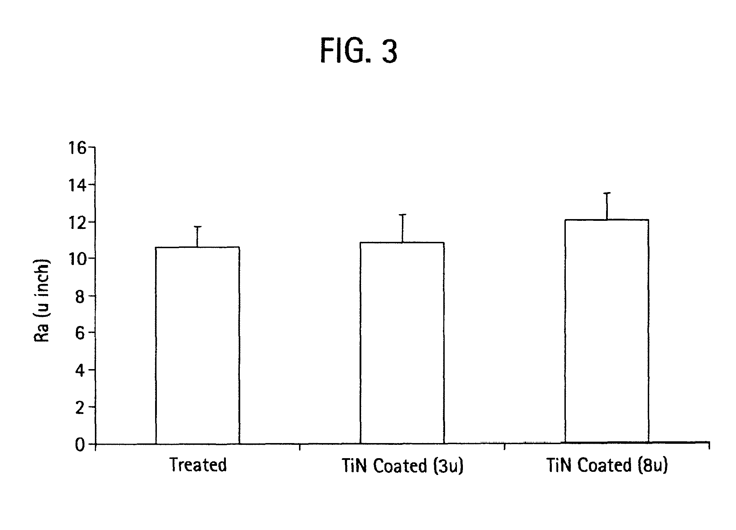

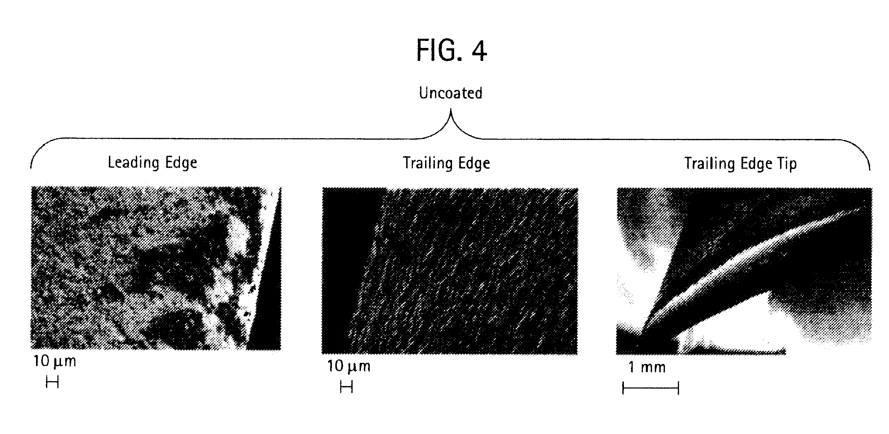

FIG. 3 graphically illustrates a comparison of surface roughness. Notably, it was observed that the deposition of TiN by EB-PPVD did not contribute to any significant additional roughness. FIG. 4 provides scanning electron micrographs of the leading edge, trailing edge, and trailing edge tip for the uncoated turbine blade components Qualitatively, extensive sand accumulation was visually observed on both the convex and concave surfaces for the uncoated turbine blade components whereas the treated and coated turbine blade components were relatively free from sand accumulation. As shown, sand accumulation was clearly evident at the leading edge of the uncoated turbine blade component

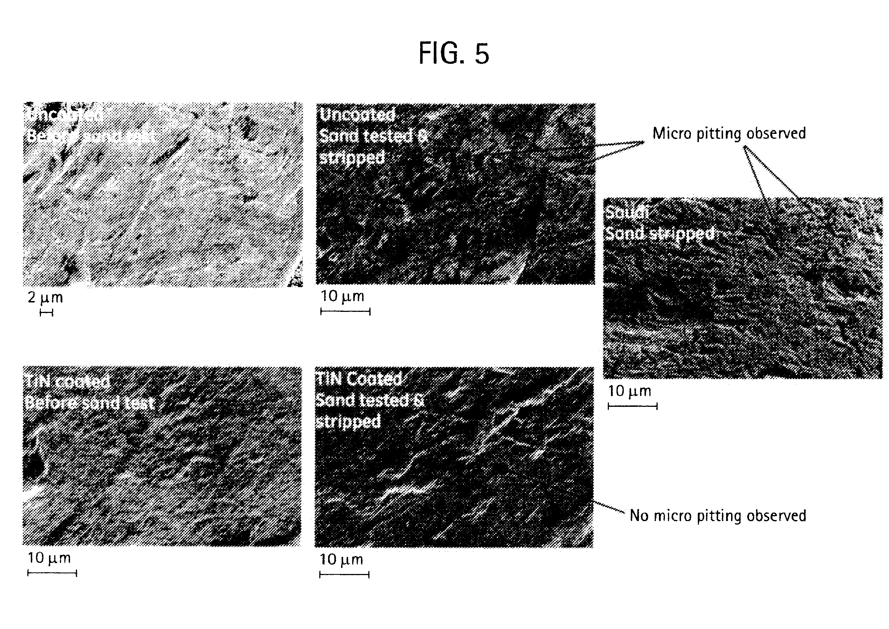

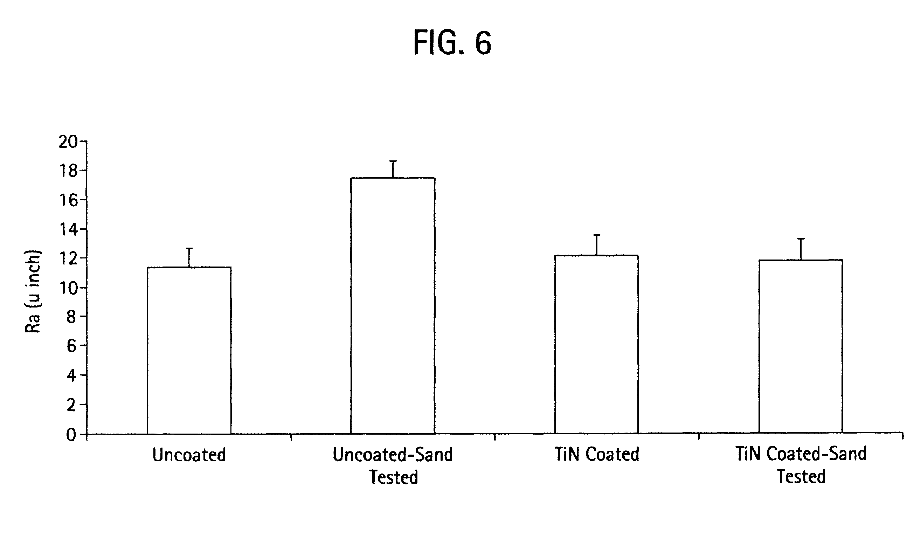

FIG. 5 provides scanning electron micrographs after sand stripping. As shown, micropitting was readily observed for the uncoated surfaces whereas the treated and coated surfaces exhibited no discernable micropitting. FIG. 6 graphically illustrates surface roughness for coated and uncoated turbine blade components after exposure to a sand erosion test and stripping process. The combination of a titanium nitride coating on a treated surface exhibited negligible surface damage. In contrast, the uncoated and processed turbine component surfaced displayed a significant increase in surface roughness, which can be attributed to micropitting upon impact with the sand particles. The standard finish for blades resulted in a surface roughness of 16 microinches. The treated surface, on the other hand, has a surface roughness value of less than 12 microinches.

While the disclosure has been described with reference to exemplary embodiments, it will be understood by those skilled in the art that various changes may be made and equivalents may be substituted for elements thereof without departing from the scope of the disclosure. In addition, many modifications may be made to adapt a particular situation or material to the teachings of the disclosure without departing from the essential scope thereof. Therefore, it is intended that the disclosure not be limited to the particular embodiment disclosed as the best mode contemplated for carrying out this disclosure, but that the disclosure will include all embodiments falling within the scope of the appended claims.

Also, the terms "first", "second", "bottom", "top", and the like do not denote any order, quantity, or importance, but rather are used to distinguish one element from another; and the terms "the", "a", and "an" do not denote a limitation of quantity, but rather denote the presence of at least one of the referenced items. The modifier "about" used in connection with a quantity is inclusive of the stated value and has the meaning dictated by the context or includes at least the degree of error associated with measurement of the particular quantity. Furthermore, all ranges reciting the same quantity or physical property are inclusive of the recited endpoints and independently combinable.

For completeness, various aspects of the invention are set out in the following numbered clauses:
1. A surface of a turbine engine component that is resistant to sand fouling, the surface comprising:
   a substrate; and
   a carbide and/or nitride coating deposited thereon, wherein the coated surface has a roughness (Ra) of less than 12 microinches.
2. The surface of the turbine engine component of clause 1, wherein the carbide and/or nitride coating comprises a nitride or a carbide material at a thickness of less than 25 microns formed using electron beam physical vapor deposition or magnetron sputtering or filtered cathodic arc evaporation.
3. The surface of the turbine engine component of clause 1, wherein the substrate comprises a steel, a superalloy, or a titanium alloy.
4. The surface of the turbine engine component of clause 1, wherein the turbine engine component comprises a shroud, a bucket, a blade, a nozzle, a vane, a diaphragm component, a seal component, or a valve stem.
5. The surface of the turbine engine component of clause 1, wherein the carbide and/or nitride coating is selected from a group consisting of Cr₃C₂, WC, TiC, ZrC, B₄C, BN, TiN, ZrN, HfN, CrN, Cr₂N, Si₃N₄, AlN, TiAlN, TiAlCrN, TiCrN, CrAlN, TiZrN, CrBN, TiSCN, TiBN, combinations of carbides and nitrides, ceramic-metal carbide composites, and combinations comprising at least one of the foregoing.
6. The surface of the turbine engine component of clause 1, wherein the carbide and/or nitride coating is TiN.
7. The surface of the turbine engine component of clause 1, wherein the carbide and/or nitride coating has a hardness of less than or equal to about 5000 kilograms per square millimeter.
8. The surface of the turbine engine component of clause 1, wherein the substrate comprises a treated surface having a roughness (Ra) of less than 12 microinches.
9. A method for substantially preventing micropitting on a surface of a turbine engine component, comprising:
   treating the surface of the turbine engine component to provide an average roughness (Ra) of less than 12 microinches; and
   depositing a nitride and/or a carbide coating onto the treated surface at a thickness of less than 50 microns by electron beam physical vapor deposition, cathodic arc evaporation, or magnetron sputtering.
10. The method of clause 9, wherein treating the surface comprises an isotropic superfinishing process that provides the surface with a non-directional surface texture.
11. The method of clause 9, wherein treating the surface comprises placing one or more of the turbine engine components in a vibratory finishing system; adding solid media and chemical solutions to the system; and providing vibratory movement.
12. The method of clause 9, wherein the nitride and/or a carbide coating deposited onto the treated surface has an average roughness within about 1 to about 10 percent of the average roughness of the treated surface.
13. The method of clause 9, wherein the turbine engine component comprises a steel, a superalloy, or a titanium alloy.
14. The method of clause 9, wherein the turbine engine component comprises a shroud, a bucket, a blade, a nozzle, a vane, a diaphragm component, a seal component, or a valve stem.
15. The method of clause 9, wherein the nitride and/or the carbide coating is selected from a group consisting of Cr₃C₂, WC, TiC, ZrC, B₄C, BN, TiN, ZrN, HfN, CrN, Cr₂N, Si₃N₄, AlN, TiAlN, TiAlCrN, CrAlN, TiSiCN, TiCrN, TiZrN, CrBN, TiBN, combinations of carbides and nitrides, ceramic-metal carbide composites, and combinations comprising at least one of the foregoing.
16. The method of clause 9, wherein the nitride and/or the carbide coating is TiN.
17. The method of clause 9, wherein the nitride and/or the carbide coating has a hardness of less than or equal to about 5000 kilograms per square millimeter.
18. A method for substantially preventing micropitting on a surface of a turbine engine component, comprising:
   depositing a nitride and/or a carbide coating onto the surface at a thickness of less than 50 microns by electron beam physical vapor deposition, cathodic arc evaporation, or magnetron sputtering; and
   treating the coated surface of the turbine engine component to provide an average roughness (Ra) of less than 12 microinches.
19. The method of clause 18, wherein the nitride and/or the carbide coating is selected from a group consisting of Cr₃C₂, WC, TiC, ZrC, B₄C, BN, TiN, ZrN, HfN, CrN, Cr₂N, Si₃N₄, AlN, TiAlN, TiAlCrN, CrAlN, TiSiCN, TiCrN, TiZrN, CrBN, TiBN, combinations of carbides and nitrides, ceramic-metal carbide composites, and combinations comprising at least one of the foregoing.
20. The method of clause 18, wherein the nitride and/or the carbide coating has a hardness of less than or equal to about 5000 kilograms per square millimeter.

## Claims

1. A surface (14) of a turbine engine component (10) that is resistant to sand fouling, the surface (14) comprising:
a substrate (12); and
a carbide and/or nitride coating deposited thereon to form a coated surface (16), wherein the coated surface has a roughness (Ra) of less than 12 microinches.

2. The surface (14) of the turbine engine component (10) of Claim 1, wherein the carbide and/or nitride coating (16) comprises a nitride and/or a carbide material at a thickness of less than 25 microns formed using electron beam physical vapor deposition or magnetron sputtering or filtered cathodic arc evaporation.

3. The surface (14) of the turbine engine component (10) of any one of the preceding claims, wherein the substrate (12) comprises a steel, a superalloy, or a titanium alloy.

4. The surface (14) of the turbine engine component (10) of any one of the preceding claims, wherein the turbine engine component comprises a shroud, a bucket, a blade, a nozzle, a vane, a diaphragm component, a seal component, or a valve stem.

5. The surface (14) of the turbine engine component (10) of any one of the preceding claims, wherein the carbide and/or nitride coating (16) is selected from a group consisting of Cr₃C₂, WC, TiC, ZrC, B₄C, BN, TiN, ZrN, HfN, CrN, Cr₂N, Si₃N₄, AlN, TiAIN, TiAlCrN, TiCrN, CrAlN, TiZrN, CrBN, TiSCN, TiBN, combinations of carbides and nitrides, ceramic-metal carbide composites, and combinations comprising at least one of the foregoing.

6. The surface (14) of the turbine engine component (10) of any one of the preceding claims, wherein the carbide and/or nitride coating (16) has a hardness of less than or equal to about 5000 kilograms per square millimeter.

7. The surface (14) of the turbine engine component (10) of any one of the preceding claims, wherein the substrate (12) comprises a treated surface having a roughness (Ra) of less than 12 microinches.

8. A method for substantially preventing micropitting on a surface (14) of a turbine engine component (10), comprising:
treating the surface (14) of the turbine engine component (10) to provide an average roughness (Ra) of less than 12 microinches; and
depositing a nitride and/or a carbide coating (16) onto the treated surface at a thickness of less than 50 microns by electron beam physical vapor deposition, cathodic arc evaporation, or magnetron sputtering.

9. The method of Claim 8, wherein treating the surface (14) comprises an isotropic superfinishing process that provides the surface (14) with a non-directional surface texture.

10. The method of Claim 8 or Claim 9, wherein the nitride and/or the carbide coating (16) is selected from a group consisting of Cr₃C₂, WC, TiC, ZrC, B₄C, BN, TiN, ZrN, HfN, CrN, Cr₂N, Si₃N₄, AlN, TiAIN, TiAlCrN, CrAlN, TiSiCN, TiCrN, TiZrN, CrBN, TiBN, combinations of carbides and nitrides, ceramic-metal carbide composites, and combinations comprising at least one of the foregoing.
